# DEMANDE DE BREVET EUROPEEN

(11) **EP 0 870 458 A1**
(43) Date de publication de la demande: **14.10.1998**
(21) Numéro de dépôt: 98420044.4
(22) Date de dépôt: 11.03.1998
(51) Int. Cl.: A47J 36/02

(54) **Article culinaire a surface de contact alimentaire**

(30) Priorité: 14.03.1997 FR 9703323
(71) Demandeur: THERMOCOMPACT, 74370 Metz Tessy (FR)
(72) Inventeur: Cornier Jean-Claude, 74940 Annecy Le Vieux (FR); Lacourcelle Louis, 34700 St. Jean De La Blaquiere (FR)
(74) Mandataire: Poncet, Jean-François

(57) **Abrégé**

Selon l'invention, une résistance électrique pour article culinaire comprend un substrat métallique (1) dont la surface de contact (2) est formée d'une couche superficielle (3) en nitrure de titane, en nitrure de zirconium ou en aluminium anodisé. On obtient ainsi une surface de contact alimentaire ayant une bonne tenue aux chocs thermiques, une faible adhérence du tartre, et une grande résistance aux agressions mécaniques.

## Description

La présente invention concerne les articles culinaires destinés à être en contact avec des matières alimentaires, et en particulier avec des matières alimentaires solides ou liquides à des températures pouvant aller au moins jusqu'à leur température de cuisson ou d'ébullition.

Dans les applications les plus courantes de récipients pour la cuisson, la surface de contact avec les matières alimentaires est généralement constituée par la surface extérieure du substrat métallique lui-même, en aluminium ou en acier inoxydable, ou par une couche superficielle d'étain recouvrant un substrat en cuivre, ou par une couche anti-adhésive à base de polytétrafluoroéthylène recouvrant le substrat.

Le document EP 0 489 914 A décrit une poêle à frire dont la surface intérieure est revêtue de nitrure de titane. Le document DE 31 42 312 A décrit des récipients de cuisine tels que des marmites ou poêles, dont la surface intérieure est revêtue de nitrure de titane, de carbure de titane, de carbure de chrome ou d'oxyde d'aluminium. Le document FR 2 538 236 A décrit un récipient de cuisine tel qu'une poêle en aluminium dont la surface intérieure est en aluminium anodisé.

Dans les applications connues de résistances électriques destinées à être en contact avec les matières alimentaires, la surface de contact de la résistance peut être la surface externe d'une couche superficielle en un matériau différent du substrat. On considère que de telles surfaces de contact alimentaire de résistances électriques doivent, dans la gamme des températures de cuisson habituelles, résister aux cycles thermiques, éviter toute émission de métal nocif dans les matières alimentaires, et s'opposer à l'adhérence du tartre. Les contraintes sont plus sévères que celles supportées par les surfaces intérieures des récipients.

Le document EP 0 656 740 A décrit une couche superficielle de résistance électrique en or ou en palladium, ou en alliage étain-nickel. Pour des questions de coût, la couche superficielle est de préférence très mince. On sait que l'or est particulièrement inaltérable, de sorte que l'utilisateur attache des propriétés particulièrement bénéfiques à une surface de contact alimentaire constituée en or. Cependant, de telles couches superficielles de contact en or sont onéreuses. De plus, ces couches superficielles en or sont relativement fragiles, susceptibles d'être détériorées par les chocs ou les contacts avec des ustensiles culinaires telles que des cuillères lors du brassage des aliments en cours de cuisson. Les couches réalisées à l'aide des autres métaux ou alliages cités n'ont pas de bonnes capacités à s'opposer à l'adhérence du tartre.

Selon le document DE 35 12 659 A, la surface de contact d'une résistance électrique peut être en une céramique telle que l'oxyde d'aluminium. Une telle surface ne présente pas une bonne capacité à s'opposer à l'adhérence du tartre.

Le problème proposé par la présente invention est de concevoir de nouvelles structures de résistances électriques pour éléments culinaires à surface de contact alimentaire dans lesquelles la surface de contact soit réalisée de manière plus économique, tout en présentant une plus grande résistance aux chocs et autres dégradations en cours d'usage, une bonne capacité de tenue aux cycles thermiques, une grande inaltérabilité pour éviter toute émission de métal non alimentaire nocif dans les aliments, et tout en s'opposant de façon plus efficace à l'adhérence du tartre sur ladite surface de contact.

On veut en outre pouvoir réaliser une telle surface de contact alimentaire présentant un aspect coloré ou non, par exemple doré, similaire à l'aspect d'une surface en or.

Pour cela, selon l'invention, une résistance électrique pour article culinaire, ayant un substrat métallique et une surface de contact alimentaire pour le contact avec des matières alimentaires solides ou liquides à des températures pouvant aller au moins à leur température de cuisson, comprend une surface de contact constituée de la surface externe d'une couche superficielle en l'une des céramiques de la famille de céramiques comprenant le nitrure de titane, le nitrure de zirconium, et l'alumine en surface de l'aluminium anodisé.

Dans le cas de l'aluminium anodisé, la couche superficielle peut avantageusement enfermer un colorant jaune. Dans le cas du nitrure de titane ou du nitrure de zirconium, la couche peut être naturellement de couleur dorée.

Ces couches présentent les caractéristiques recherchées, en particulier une grande dureté et une meilleure capacité à s'opposer à l'adhérence du tartre sur la surface de contact.

Pour diminuer encore les risques d'émission de métal sous-jacent constituant le substrat métallique, par exemple en cas de détérioration locale de la couche superficielle, ladite couche superficielle en nitrure de titane ou en nitrure de zirconium peut avantageusement recouvrir une couche intermédiaire appropriée formant barrage isolant le substrat métallique en cas de détérioration locale de ladite couche superficielle.

Dans le cas des couches de nitrure de titane ou de nitrure de zirconium, la couche superficielle est déposée sur le substrat par toute méthode physique appropriée telle que condensation sous vide de vapeur métallique en présence d'un gaz réactif à base d'azote.

La couche d'aluminium anodisé est réalisée par électrolyse et colmatage par hydratation.

De telles couches superficielles alimentaires de résistances électriques présentent des propriétés particulièrement avantageuses, assurant une bonne tenue aux cycles thermiques, une faible adhérence du tartre, une excellente tenue aux chocs ou agressions mécaniques, une excellente inaltérabilité, tout en présentant éventuellement un aspect doré susceptible de rassurer le consommateur.

D'autres objets, caractéristiques et avantages de la présente invention apparaîtront à la lecture de la description suivante, faite en relation avec les figures jointes dans lesquelles :
- la figure 1 est une vue schématique partielle en coupe d'une résistance électrique pour article culinaire muni d'une surface de contact à couche superficielle selon un mode de réalisation de la présente invention ; et
- la figure 2 est une vue schématique partielle en coupe d'une résistance électrique pour article culinaire à couche superficielle et couche intermédiaire selon un second mode de réalisation de la présente invention.

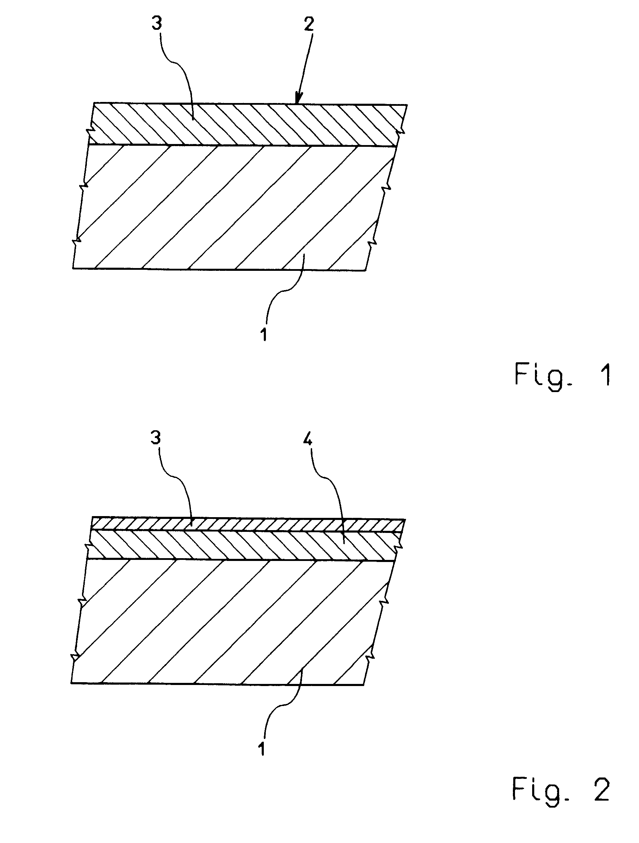

Comme le représente la figure 1, une résistance électrique pour article culinaire selon l'invention comporte un substrat 1 métallique et une surface de contact 2 constituée de la surface externe d'une couche superficielle 3 en une céramique telle que le nitrure de titane, le nitrure de zirconium et l'aluminium anodisé.

La couche superficielle 3, dans le cas du nitrure de titane et du nitrure de zirconium, peut être réalisée par enrobage du substrat 1 par toute méthode physique appropriée, par exemple par condensation sous vide de vapeur métallique en présence d'un gaz réactif à base d'azote (méthode PVD).

Dans le cas d'une couche superficielle 3 en aluminium anodisé, le substrat 1 est lui-même en aluminium, et la couche superficielle 3 est réalisée par une étape d'électrolyse suivie d'une étape d'hydratation assurant un colmatage. Dans ce cas, la couche superficielle en aluminium anodisé peut avantageusement enfermer un colorant jaune reproduisant l'aspect d'une couche en or.

Dans le mode de réalisation de la figure 2, la couche superficielle 3, en nitrure de titane ou en nitrure de zirconium, recouvre une couche intermédiaire 4 recouvrant elle-même le substrat 1. La couche intermédiaire 4 peut être en tout matériau approprié et compatible à la fois avec le substrat 1 et avec la couche superficielle 3, et forme barrage pour isoler le substrat métallique 1 en cas en détérioration locale ultérieure de la couche superficielle 3.

L'invention s'applique à la constitution de la surface de contact alimentaire d'une résistance électrique.

Toutefois, indépendamment de la présence ou de la constitution d'une résistance électrique, la surface de contact intérieure d'un récipient culinaire tel que poêle, casserole, bouilloire ou autre peut avantageusement être la surface apparente d'une couche superficielle en nitrure de zirconium. On obtient alors un excellent compromis concernant le coût de réalisation et les propriétés mécaniques, chimiques et esthétiques de la surface de contact alimentaire.

La présente invention n'est pas limitée aux modes de réalisation qui ont été explicitement décrits, mais elle en inclut les diverses variantes et généralisations contenues dans le domaine des revendications ci-après.

## Revendications

1. Résistance électrique pour article culinaire, ayant un substrat métallique (1) et une surface de contact (2) alimentaire pour le contact avec les matières alimentaires solides ou liquides, caractérisée en ce que ladite surface de contact (2) est la surface externe d'une couche superficielle en l'une des céramiques de la famille de céramiques comprenant le nitrure de titane, le nitrure de zirconium, et l'alumine en surface de l'aluminium anodisé.

2. Résistance électrique selon la revendication 1, caractérisée en ce que la couche superficielle (3) est en aluminium anodisé enfermant un colorant jaune.

3. Résistance électrique selon la revendication 1, caractérisée en ce que ladite couche superficielle (3) en nitrure de titane ou en nitrure de zirconium recouvre une couche intermédiaire appropriée (4) formant barrage isolant le substrat métallique (1) en cas de détérioration locale de ladite couche superficielle (3).

4. Résistance électrique selon l'une des revendications 1 ou 3, caractérisée en ce que ladite couche superficielle de nitrure de titane ou de nitrure de zirconium est déposée sur le substrat (1) par une méthode physique telle que condensation sous vide de vapeur métallique en présence d'un gaz réactif à base d'azote.

5. Résistance électrique selon la revendication 2, caractérisée en ce que la couche superficielle en aluminium anodisé est réalisée par une étape d'électrolyse suivie d'une étape d'hydratation assurant un colmatage.

6. Article culinaire caractérisé en ce qu'il comprend au moins une résistance électrique selon l'une quelconque des revendications 1 à 5.
